Europäisches Patentamt

European Patent Office

Office européen des brevets

(11) Numéro de publication: **0 055 672**
**B1**

(12) **FASCICULE DE BREVET EUROPEEN**

(45) Date de publication du fascicule du brevet: **13.02.85**

(21) Numéro de dépôt: **81402075.6**

(22) Date de dépôt: **24.12.81**

(51) Int. Cl.⁴: **H 03 K 17/08**

(54) **Appareil détecteur de proximité, respectivement de présence, du type à deux bornes, comportant un circuit d'alimentation en courant alternatif redressé et de commande d'une charge à l'aide de thyristors de commutation.**

(30) Priorité: **31.12.80 FR 8027870**

(43) Date de publication de la demande:
**07.07.82 Bulletin 82/27**

(45) Mention de la délivrance du brevet:
**13.02.85 Bulletin 85/07**

(84) Etats contractants désignés:
**CH DE GB IT LI SE**

(56) Documents cités:
**DE-A-2 750 992**
**DE-A-2 845 553**
**FR-A-2 234 711**
**FR-A-2 348 605**
**FR-A-2 445 075**
**FR-A-2 457 604**

(73) Titulaire: **LA TELEMECANIQUE ELECTRIQUE**
**33 bis, avenue du Maréchal Joffre**
**F-92000 Nanterre (FR)**

(72) Inventeur: **Periot, Jean-Marie**
**23 bis, Avenue de Montbron**
**F-16340 Isle d'Espagnac (FR)**

(74) Mandataire: **Marquer, Francis**
**CABINET MOUTARD 35, avenue Victor Hugo**
**Résidence Champfleury**
**F-78180 Voisins le Bretonneux (FR)**

Courier Press, Leamington Spa, England.

EP 0 055 672 B1

# Description

L'invention se rapporte aux appareils détecteurs de proximité, respectivement de présence, du type à deux bornes, alimentés en courant alternatif et comportant un capteur associé à un circuit de commande, qui sont montés en série avec la charge à commander, et plus particulièrement aux dispositifs d'alimentation, de commande du courant de sortie et de protection contre les surcharges ou les courts-circuits, que comportent de tels appareils.

A titre d'exemple, il s'agit de détecteurs à cellule photoélectrique, du type capacitif, ou autres.

Dans ces appareils, la commande de la charge est fréquemment réalisée en rendant conducteur au moins un thyristor lorsque le capteur délivre un signal de commande, ce qui provoque la circulation dans la charge, à travers le circuit, d'un courant, appelé courant de sortie, d'intensité suffisante pour commander la charge.

Ces appareils comportent généralement, en plus du capteur et du circuit de commande, des moyens de redressement du courant servant à l'alimentation de l'appareil, une résistance, en série avec l'ensemble capteur-circuit de commande et qui sert à alimenter ce dernier lorsque la charge est au repos, et une diode de Zener, connectée aux bornes de cet ensemble et en série avec le thyristor afin de définir une tension de référence.

Un appareil du genre susvisé est notamment décrit dans FR—A—2 457 604 déposé par la Demanderesse le 25 Mai 1979.

Dans ce type d'appareil, il importe de ne pas perturber le fonctionnement de la charge en réduisant la tension aux bornes de l'appareil lorsque la charge est commandée. La tension aux bornes de l'appareil, alors appelée tension de déchet, devra donc être la plus faible possible.

Un inconvénient des appareils de l'art antérieur réside dans le fait que lorsque le thyristor est rendu conducteur, la reprise de la commande de celui-ci ne peut se faire que lorsque le courant qui le traverse est voisin de zéro. Ceci ne permet pas d'assurer la protection du montage lorsqu'une surcharge ou un court-circuit se produit alors qu'un ordre de commande de la charge est fourni par le capteur, et que le thyristor est donc conducteur.

L'invention se propose de supprimer cet inconvénient en réalisant un appareil détecteur de proximité, respectivement de présence, du type à deux bornes alimenté par un courant alternatif redressé servant à commander une charge branchée en série avec ledit appareil, et comportant: un ensemble capteur-circuit de commande; au moins un premier thyristor et une diode de Zener montés en série et en opposition, la gâchette du premier thyristor étant reliée à la sortie de l'ensemble capteur-circuit de command rendant le premier thyristor conducteur ou non-conducteur afin de commander la charge, ledit ensemble étant alimenté par lesdits moyens de redressement, aux bornes de la diode de Zener ou à travers une première résistance selon que, respectivement, le premier thyristor est ou n'et pas conducteur; et un premier condensateur, connecté en parallèle sur la diode de Zener et servant de source d'alimentation audit ensemble capteur-circuit de commande lors des minima d'intensité du courant redressé qui traverse l'appareil, caractérisé en ce qu'il comporte des moyens de protection comprenant un composant semi-conducteur à fort gain monté en série avec le premier thyristor, comportant une entrée et une sortie de puissance et au moins une entrée de commande, un transistor monté en parallèle entre ladite entrée de commande et la sortie dudit composant semi-conducteur, de manière telle que ledit transistor, normalement non saturé, se sature lorsqu'une surcharge ou une court-circuit de charge se produit et que la saturation dudit transistor provoque le blocage du composant semi-conducteur et, par suite, la limitation du courant dans le premier thyristor.

On a déjà proposé, dans DE—A—2 845 553, un dispositif électronique de commutation dont l'organe de commande comporte des moyens de limiter l'intensité du courant comprenant un composant semi-conducteur monté en série avec un thyristor, et comportant une entrée et une sortie de puissance et au moins une entrée de commande.

Pour obtenir une tension de déchet aussi faible que possible l'invention propose par ailleurs d'utiliser un second thyristor monté en série avec les moyens de protection et en parallèle sur le premier thyristor et la diode de Zener.

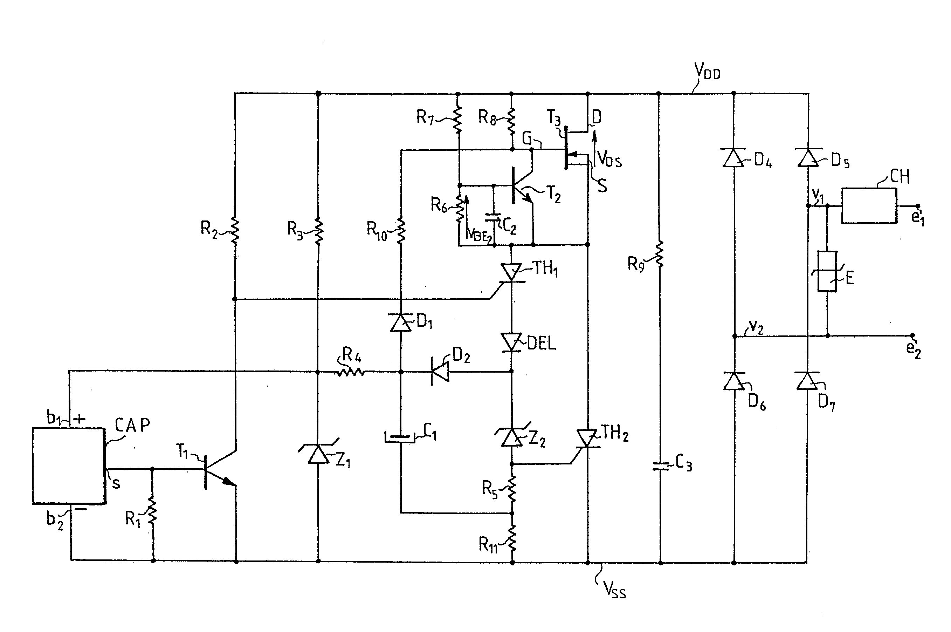

Les diverses particularités, ainsi que les avantages de l'invention, apparaîtront clairement à la lumière de la description ci-après, accompagnée de la figure unique du dessin annexé, qui représente le schéma d'un appareil du type deux bornes conforme à un mode d'exécution préféré de l'invention.

Le montage représenté à la figure unique est alimenté en tension alternative par l'intermédiaire de deux bornes d'alimentation $e_1$, $e_2$ reliées à un pont redresseur à double alternance à diodes $D_4$—$D_7$ par deux conducteurs d'alimentation respectivement $v_1$ et $v_2$, sur l'un desquels est connecté en série une charge CH pouvant être par exemple un relais. Le pont redresseur fournit à ses bornes une tension redressée alimentant le reste du montage par l'intermédiaire de deux conducteurs d'alimentation $V_{DD}$ (polarité positive) et $V_{SS}$ (polarité négative). Un ensemble (CAP) capteur-circuit de commande de la charge comportant par exemple un photo-transistor possédant deux bornes d'alimentation positive $b_1$ et négative $b_2$ et une sortie s. La borne négative $b_2$ est directement reliée à $V_{SS}$, la borne positive $b_1$ étant reliée à $V_{DD}$ par l'intermédiaire d'une résistance

$R_3$, une diode de Zener $Z_1$ étant montée en parallèle sur les bornes $b_1$ $b_2$ et ayant son anode reliée au conducteur de polarité négative et sa cathode reliée à la borne d'alimentation positive. La sortie s est reliée à la base d'un transistor $T_1$, par exemple de type NPN, dont l'émetteur est connecté à $V_{SS}$ et le collecteur est relié à $V_{DD}$ par l'intermédiaire d'une résistance $R_2$, une résistance de polarisation $R_1$ étant montée entre la base de ce transisor $T_1$ et $V_{SS}$. Le collecteur du transistor $T_1$ est connecté à la gâchette d'un premier thyristor $TH_1$ dont la cathode est reliée à $V_{SS}$ par l'intermédiaire et dans l'ordre où elles sont citées d'une diode électroluminescente DEL montée avec la même polarité que le thyristor, servant à signaler l'état au repos ou en charge de CH, d'une diode de Zener $Z_2$, montée en opposition au thyristor, d'une résistance $R_5$ et d'une résistance $R_{11}$. L'anode du thyristor $TH_1$ est reliée à l'émetteur d'un transistor, par exemple de type NPN, $T_2$ dont la base est polarisée par un pont de résistances $R_7$ et $R_6$. La résistance $R_7$ est reliée directement à $V_{DD}$; la résistance $R_6$ est montée en parallèle sur la jonction base-émetteur de transistor $T_2$, un condensateur de retard $C_2$ est lui aussi monté en parallèle sur cette jonction base-émetteur. Le collecteur de $T_2$ est relié à la grille d'un transistor $T_3$ avantageusement du type MOS. Le transistor $T_3$ est monté en série avec un deuxième thyristor $TH_2$ entre les deux conducteurs d'alimentation $V_{DD}$ et $V_{SS}$, son drain étant relié à $V_{DD}$ et sa source étant reliée à la fois à l'anode de $TH_2$ et à celle de $TH_1$; la gâchette de $TH_2$ est connectée à l'anode de $Z_2$. D'autre part, la grille du transistor $T_3$ est polarisée à travers une résistance $R_8$ montée entre sa grille et le conducteur $V_{DD}$ et par l'intermédiaire d'une résistance $R_{10}$ montée en série avec une première diode $D_1$ et une deuxième diode $D_2$ montée selon le même sens, l'anode de $D_2$ étant reliée à la cathode de $Z_2$. Par ailleurs, la cathode de $D_2$ est aussi reliée à la borne $b_1$ par l'intermédiaire d'une résistance $R_4$; un condensateur $C_1$ sert de réservoir d'alimentation pour l'ensemble CAP et est monté en parallèle sur l'ensemble constitué par la diode $D_2$, la diode de Zener $Z_2$ et la résistance $R_5$. Une résistance $R_9$ et un condensateur de filtrage $C_3$ sont montés en série entre les deux conducteurs d'alimentation $V_{DD}$ et $V_{SS}$. Enfin, une résistance non linéaire E est montée entre les conducteurs d'alimentation en énergie alternative $v_1$ et $v_2$ en aval de la charge CH.

Lorsque la charge CH est au repos, c'est-à-dire lorsqu'aucun ordre de commande de la charge n'est détecté par le capteur de l'ensemble CAP, le transistor $T_1$ est saturé, la polarisation fournie à la sortie étant appropriée à cet effet. Les thyristors $TH_1$ et $TH_2$ sont bloqués et l'ensemble CAP est alimenté sous une tension fixée par la diode de Zener $Z_1$; la résistance $R_3$ limite le courant circulant dans le montage, donc le courant traversant la charge CH montée en série sur l'un des conducteurs d'alimentation en courant alternatif, évitant ainsi que ce courant ne perturbe le fonctionnement de la charge CH.

Lorsque le capteur de l'ensemble CAP reçoit un ordre de commande de la charge, cet ordre est transmis à la sortie s de l'ensemble CAP qui bloque le transistor $T_1$. Le thyristor $TH_1$ est alors amorcé à travers la résistance $R_2$. L'ensemble constitué des deux transistors $T_2$ et $T_3$, des résistances $R_6$, $R_7$ et $R_8$, et du condensateur $C_2$, est mis sous tension. Le transistor $T_3$, polarisé par la résistance $R_8$, atteint son seuil de saturation avant que le transistor $T_2$ n'atteigne le sien du fait du condensateur de retard $C_2$ qui ralentit la montée en tension de la base de $T_2$ par rapport à l'émetteur de $T_2$. Une tension $V_{DS}$ apparaît entre le drain et la source du transistor $T_3$; cette tension est insuffisante en l'absence de surcharge, pour amener le transistor $T_2$ dans son état saturé, les valeurs des résistances, de polarisation du transistor $T_2$, $R_6$ et $R_7$ étant choisies à cet effet.

Le transistor $T_3$ et le thyristor $TH_1$ étant saturés, le condensateur $C_1$ est rapidement chargé jusqu'à une tension telle que la diode de Zener $Z_2$ devienne conductrice et permette l'amorçage du thyristor $TH_2$. Ce dernier court-circuite alors $TH_1$ et la diode de Zener $Z_2$, réduisant ainsi la tension de déchet à la chute de tension dans le pont de diodes, augmentée de la chute de tension dans le transistor $T_3$ et le thyristor $TH_2$.

A chaque minimum du courant de charge $I_s$, le thyristor $TH_2$ devient non conducteur, et lorsque le courant de charge recommence à croître, la séquence: thyristor $TH_1$ conducteur, charge de $C_1$, thyristor $TH_2$ conducteur, décrite précédemment, se reproduit. Ce processus a pour effet de réduire notablement la valeur moyenne de la tension de déchet. Les valeurs des résistances $R_{11}$ et $R_5$ sont choisies de telle sorte que l'élévation de potentiel aux bornes de $R_{11}$ due au courant de charge du condensateur $C_1$ n'est pas suffisante dans des conditions normales de fonctionnement pour polariser la gâchette du thyristor $TH_2$, de façon à le rendre conducteur, alors que l'élévation de potentiel aux bornes de $R_5$ et $R_{11}$ en série, lorsque la diode de Zener $Z_2$ est passante, est suffisante pour rendre le thyristor $TH_2$ conducteur. C'est ce qui explique que $TH_2$ ne s'amorcera que lorsque $Z_2$ sera passante.

Lorsque $TH_2$ est conducteur, la source de $T_3$ est sensiblement amenée au potentiel bas du circuit, la polarisation de grille de $T_3$ est alors fournie par le condensateur $C_1$, à travers $D_1$ et $R_{10}$. La saturation de $T_3$ est ainsi assurée malgré la faible tension de déchet.

Le condensateur $C_1$ sert aussi de réservoir d'alimentation en énergie pour l'ensemble CAP lorsque le thyristor $TH_2$ est conducteur, la tension aux bornes du pont étant alors insuffisante. Lorsqu'une surcharge ou un court-circuit se produit en cours de fonctionnement au niveau de la charge CH, le courant $I_s$ traversant

le montage et, par suit, le courant traversant le transistor $T_3$ croît. Cet accroissement du courant traversant $T_3$ provoque une augmentation de la tension drain-source du transistor $T_3$; celle-ci étant liée aux valeurs du courant I la traversant et à la résistance $R_{ON}$ drain-source du transistor $T_3$ à l'état passant par la relation:

$$V_{DS}=R_{ON}\times I$$

L'accroissement de cette tension $V_{DS}$ a pour conséquence l'augmentation de la tension base-émetteur $V_{BE2}$ du transistor $T_2$, celle-ci étant liée à la tension drain-source de $T_3$ par l'intermédiaire du pont de résistances $R_7$, $R_6$ aux bornes duquel est appliquée $V_{DS}$.

La relation entre les deux tensions et les deux résistances s'écrit:

$$V_{BE2}=V_{DS}\frac{R_6}{R_6+R_7}$$

Dès que cette tension $V_{BE2}$ atteint environ 0,6 V, le transistor $T_2$ se sature et bloque le transistor $T_3$, rendant ainsi le thyristor $TH_2$ non conducteur, le courant traversant $T_2$ étant inférieur au courant de maintien du thyristor $TH_2$.

Le thyristor $TH_1$, dont la gâchette est polarisée par la résistance $R_2$, maintient le transistor $T_2$ en son état saturé, la tension $V_{DD}$ étant filtrée par $R_9$ $C_3$. Le courant dans la charge se trouve finalement limité au courant circulant dans $T_2$ et $TH_1$.

Pour remettre le circuit en fonctionnement, le blocage du transistor $T_2$ sera obtenu, soit en saturant le transistor $T_1$, c.a.d. en désamorçant le thyristor $TH_1$, soit en débranchant un des fils d'alimentation de l'appareil.

Le circuit décrit ci-dessus ($T_1$, $T_2$ associés à $R_6$, $R_7$, $R_8$, $R_{10}$, $C_1$ et $D_1$) réalise donc bien une protection de l'appareil en cas de surcharge ou court-circuit lorsque la charge est commandée. L'utilisation d'un transistor MOS permet de réaliser un circuit de commande de la charge ne consommant qu'un courant négligeable vis-à-vis du courant nécessaire pour commander la charge, donc ne perturbant pas le fonctionnement de celle-ci. En effet, le courant de grille nécessaire pour commander le transistor MOS est de l'ordre de la centaine de nanoampères (100 à 200 nA), alors que le courant traversant le canal peut atteindre des intensités de l'ordre de l'ampère, ce qui permet de réaliser un circuit de commande et de protection dans lequel les courants qui circulent sont de très faible intensité, donc consommant une faible énergie, ce qui est un avantage dans ce genre d'appareil.

Lorsque l'ordre de commande émis par le capteur de l'ensemble CAP amorce le thyristor $TH_1$ en présence d'un court-circuit de charge, la diode DEL et le condensateur $C_1$ pourraient être détruits si la protection de l'ensemble du montage était réglée pour fonctionner pour des courants supérieurs à ceux admissibles par ces deux composants.

Afin d'éviter cette destruction, la valeur de la résistance $R_{11}$ est choisie pour que la différence de potentiel à ses bornes soit suffisamment élevée pour provoquer l'amorçage du thyristor $TH_2$ lorsqu'elle est traversée par un courant dont la valeur est proche de la limite admissible par les deux composants $C_1$ et DEL, le thyristor $TH_2$ dérivant le courant comme décrit précédemment. La résistance non-linéaire E permet la protection de l'appareil conre les surtensions d'origine selfique pouvant apparaître aux bornes de la charge lors du blocage du transistor $T_3$, lorsque la charge comporte des inductances.

Le montage décrit ci-dessus permet donc de limiter la tension de déchet en série avec la charge par la mise en service d'un deuxième thyristor, le courant traversant les thyristors et la charge étant commandée par l'intermédiaire de la commande du transistor MOS. L'usage de ce type de transistor dans le circuit présente l'avantage de réaliser un circuit de commande et de protection, qui ne nécessite que des courants de très faible intensité pour son fonctionnement, qui ne risquent donc pas d'influencer le fonctionnement de la charge. Ce montage présente aussi l'avantage de protéger les composants pour lesquels le courant admissible est inférieur à celui pour lequel la protection est conçue, en cas d'amorçage sur un court-circuit de charge, par la mise en service du deuxième thyristor, ce qui a pour effect de dériver le courant, qui aurait pu les détruire, à travers ce dernier. Il va de soi que le montage décrit pourra faire l'objet de variantes d'exécution, sans s'écarter de l'invention. Par exemple, il pourra ne comporter qu'un seul thyristor $TH_1$, le thyristor $TH_2$ de même que les composants $R_5$, $R_{11}$, $C_1$, $D_1$ et $R_{10}$ étant alors supprimés. Un tel montage présentera l'inconvénient d'avoir une tension de déchet supérieure à celle obtenue dans le montage de la figure. Dans ce cas aussi, la protection du montage par la réduction du courant circulant dans le montage lorsque celui-ci atteint un certain seuil lors d'une surcharge ou d'un court-circuit de charge est obtenue grâce à la saturation du transistor $T_2$ qui provoque le blocage du transistor $T_3$ et réduit ainsi le courant traversant le thyristor $TH_1$ à la valeur du courant de saturation de $T_2$.

Selon un autre mode d'exécution, le transistor $T_3$ de technologie MOS peut être remplacé par un montage de Darlington de puissance à fort gain.

## Revendications

1. Appareil détecteur de proximité, respectivement de présence, du type à deux bornes alimenté par un courant alternatif redressé ($e_1$, $e_2$, $D_4$—$D_7$) servant à commander une charge (CH) branchée en serie avec ledit appareil, et comportant: un ensemble capteur-circuit de commande (CAP); au moins un premier thyristor ($TH_1$) et une diode de Zener ($Z_2$) montés en série et en opposition, la gâchette du premier

thyristor (TH₁) étant reliée à la sortie de l'ensemble capteur-circuit de commande (CAP) rendant le premier thyristor (TH₁) conducteur ou non-conducteur afin de commander la charge (CH), ledit ensemble étant alimenté par lesdits moyens de redressement, aux bornes de la diode de Zener Z₂ ou à travers une première résistance (R₃) selon que, respectivement, le premier thyristor (TH₁) est ou n'est pas conducteur; et un premier condensateur (C₁), connecté en parallèle sur la diode de Zener (Z₂) et servant de source d'alimentation audit ensemble capteur-circuit de commande lors des minima d'intensité du courant redressé qui traverse l'appareil, caractérisé en ce qu'il comporte des moyens de protection comprenant un composant semi-conducteur (T₃) à fort gain monté en série avec le premier thyristor, comportant une entrée (D) et une sortie (S) de puissance et au moins une entrée (G) de commande, un transistor (T₂) monté en parallèle entre ladite entrée de commande (G) et la sortie dudit composant semi-conducteur (T₃), de manière telle que ledit transistor (T₂), normalement non saturé, se sature lorsqu'une surcharge ou un court-circuit de charge se produit et que la saturation dudit transistor (T₂) provoque le blocage du composant semi-conducteur (T₃) et, par suite, la limitation (par R₇ et R₈) du courant dans le premier thyristor (TH₁).

2. Appareil détecteur du type à deux bornes selon la revendication 1, caractérisé en ce que la base dudit transistor (T₂) est polarisée par un pont de secondes résistances (R₆, R₇), connecté en parallèle sur ledit composant semi-conducteur (T₃), et en ce qu'il comporte en outre, en parallèle sur sa jonction base-émetteur, un second condensateur (C₂) de retard, les valeurs dudit second condensateur de retard (C₂) et des secondes résistances (R₆, R₇) étant choisies de manière telle que le composant semi-conducteur (T₃) atteigne un état de saturation avant que ledit transistor (T₂) ne soit lui-même saturé lors de la mise sous tension dudit composant semi-conducteur et dudit transistor.

3. Appareil détecteur du type à deux bornes selon la revendication 1 ou 2, caractérisé en ce qu'il comporte des troisièmes résistances (R₅, R₁₁ connectées en série et en aval de la diode de Zener (Z₂), et un second thyristor (TH₂) monté en série avec le composant semi-conducteur (T₃), et en parallèle sur le premier thyristor (TH₁) et la diode de Zener (Z₂), de manière telle que ledit second thyristor (TH₂) dérive sensiblement la totalité du courant traversant le montage et réduise ainsi la tension de déchet due audit montage, la gâchette dudit second thyristor (TH₂) étant connectée au point commun desdites troisièmes résistances (R₅, R₁₁) et de la diode de Zener (Z₂).

4. Appareil détecteur du type à deux bornes selon la revendication 3, caractérisé en ce que le premier condensateur (C₁) pouvant servir de source d'alimentation à l'ensemble capteur-circuit de commande (CAP), est monté en série avec une première diode (D₁) et est connecté entre ladite entrée de commande (G) dudit composant semi-conducteur (T₃) et les moyens de redressement (D₄—D₇), de manière telle qu'il assure la polarisation de l'entrée de commande (G) dudit composant semi-conducteur (T₃) lorsque le second thyristor (TH₂) est passant et maintient ainsi ledit composant semi-conducteur (T₃) en son état saturé.

5. Appareil détecteur du type à deux bornes selon la revendication 4, caractérisé en ce que lesdites troisièmes résistances (R₅, R₁₁) sont composées d'au moins deux résistances montées en série, et que ledit premier condensateur (C₁) est relié au point commun desdites troisièmes résistances (R₅, R₁₁), les valeurs desdites troisièmes résistances étant telles que la polarisation du second thyristor (TH₂) ne se produise, lors de la charge dudit premier condensateur (C₁), que lorsque le courant de charge dépasse un certain seuil.

6. Appareil détecteur du type à deux bornes selon l'une quelconque des revendications 1 à 5, caractérisé en ce que le composant semi-conducteur (T₃) est un transistor du type MOS.

7. Appareil détecteur du type à deux bornes selon l'une quelconque des revendications 1 à 5, caractérisé en ce que le composant semi-conducteur (T₃) est un montage de Darlington.

**Patentansprüche**

1. Annäherungs, bzw, Anwesenheitsdetektorgerät des Zweiklemmentyps, das mit gleichgerichtetem Wechselstrom (e₁, e₂, D₄—D₇) versorgt wird, der zur Steuerung einer mit besagtem Gerät in Reihe geschalteten Last (CH) dient mit: einer Sensor-Steuerschaltungseinheit (CAP), mindestens einem Thyristor (TH₁) und einer Zenerdiode (Z₂), die in Reihe und in Opposition geschaltet sind, wobei das Gate des ersten Thyristors (TH₁) an den Ausgang der Sensor-Steuerschaltungseinheit (CAP) angeschlossen ist und so den ersten Thyristor (TH₁) leitend oder nichtleitend macht, um die Last (CH) zu steuern; besagte Einheit wird von besagter Gleichrichtervorrichtung versorgt, an den Klemmen der Zenerdiode Z₂ oder durch einen ersten Widerstand (R₃), je nachdem ob der erste Thyristor (TH₁ leitet oder nicht; und einem parallel an die Zenerdiode (Z₂) angeschlossenem Kondensator (C₁), der als Speisequelle für besagte Sensor-Steuerschaltungseinheit dient, wenn ein gleicherichteter Strom minimaler Intensität durch das Gerät fliesst, dadurch gekennzeichnet, dass es Schutzvorrichtungen hat, mit einer Hochleistungs-Halbleiterkomponente (T₃), die in Reihe an den ersten Thyristor angeschlossen ist une einen Eingang (D), einen Leistungsaugang (S) und mindestens einen Steuereingang (G), sowie einen Transistor (T₂) hat, der parallel zwischen besagten Steuereingang (G) und den Ausgang besagter Halbleiterkomponente geschaltet ist, sodass besagter Transistor (T₂), der normalerweise nicht gesättigt ist, beim Auftreten eine Überlastung oder eines Kurzschlusses gesättigt wird und die Sättigung besagten Transistors (T$_2$) die Blockierung der Halbleiterkomponente (T$_3$) hervorruft und demnach eine Strombegrenzung (durch R$_7$ und R$_8$) im ersten Thyristor (TH$_1$).

2. Detektorgerät des Zweiklemmentyps nach Anspruch 1, dadurch gekennzeichnet, dass die Basis besagten Transistors (T$_2$) durch eine Brücke zweiter parallel an besagte Halbleiterkomponente (T$_3$) angeschlossener Widerstände (R$_6$, R$_7$) polarisiert wird und dass es ausserdem, parallel an die Basis-Sender Verbindung angeschlossen, einen zweiten Regardierungskondensator (C$_2$) enthält, wobei die Werte besagten Retardierungskondensators (C$_2$) und der zweiten Widerstände (R$_6$, R$_7$) so gewält sind, dass die Halbleiterkomponente (T$_3$) einen Sättigungszustand erreicht, bevor besagter Transistor (T$_2$) seinerseits, bei der Unterspannungssetzung besagten Halbleiters und besagten Transistors gesättigt wird.

3. Detektorgerät des Zweiklemmentyps gemäss Anspruch 1 oder 2, dadurch gekennzeichnet, dass es dritte, unterhalb der Zenerdiode (Z$_2$) in Reihegeschaltete Widerstände (R$_5$, R$_6$) enthält, sowie einen zweiten Thyristor (TH$_2$), der in Reihe geschaltet ist mit der Halbleiterkomponente (T$_3$) und parallel mit dem ersten Thyristor (TH$_1$) und der Zenerdiode (Z$_2$), sodass besagter zweiter Thyristor (TH$_2$) im wesentlichen den gesamtem durch die Schaltung fliessenden Strom ableitet und so die von besagter Schaltung verursachte Offsetspannung verringert, wobei das Gate besagten zweiten Thyristors (TH$_2$) an den gemeinsamen Punkt der besagten dritten Widerstände (R$_5$, R$_6$) und der Zenerdiode (Z$_2$) angeschlossen ist.

4. Detektorgerät des Zweiklemmentyps gemäss Anspruch 3, dadurch gekennzeichnet, dass der erste Kondensator (C$_1$), der als Speisequelle für die Sensor-Steuerschaltungseinheit (CAP) dienen kann, in Reihe mit einer ersten Diode (D$_1$) und zwischen besagten Steuereingang (G) der Halbleiterkomponente (T$_3$) und die Gliechrichtervorrichtung (D$_4$—D$_7$) so geschaltet ist, dass er die Polarisierung des Steuereingangs (G) besagter Halbleiterkomponente (T$_3$) bewirkt, wenn der zweite Thyristor (TH$_2$) leitet und so besagte Halbleiterkomponente (T$_3$) in gesättigtem Zustand erhält.

5. Detektorgerät des Zweiklemmentyps gemäss Anspruch 4, dadurch gekennzeichnet, dass besagte dritte Widerstände (R$_5$, R$_{11}$) aus mindestens zwei in Reihe geschalteten Widerständen bestehen und dass besagter erster Kondensator (C$_1$) an den gemeinsamen Punkt besagter dritter Widerstände (R$_5$, R$_{11}$ angeschlossen ist, wobei die Werte besagter dritter Widerstände so gewählt sind, dass die Polarisierung des zweiten Thyristors (TH$_2$) bei Aufladung besagten ersten Kondensators (C$_1$) nur dan stattfindet, wenn der Ladestrom eine bestimmte Schwelle überschreitet.

6. Detektorgerät des Zweiklemmentyps gemäss einem der Ansprüche 1 bis 5, dadurch gekennzeichnet, dass die Halbleiterkomponente (T$_3$) ein Transistor des MOS Typs ist.

7. Detektorgerät des Zweiklemmentyps gemäss einem der Ansprüche 1 bis 5, dadurch gekennzeichnet, dass die Halbleiterkomponente (T$_3$) eine Darlingtonschaltung ist.

**Claims**

1. Proximity, respectively presence detector apparatus of the two terminal type supplied by a rectified A-C current (e$_1$, e$_2$, D$_4$—D$_7$) for controlling a load (CH) series-connected to said apparatus and comprising: a sensor-control circuit unit (CAP); at least a first thyristor (TH$_1$) and a Zener diode (Z$_2$) series and oppositely connected, the gate of the first thyristor (TH$_1$) being connected to the output of the sensor-control circuit unit (CAP) making the first thyristor (TH$_1$) conductive or not, for controlling the charge (CH), said unit being supplied by said rectifying means at the terminals of the Zener diode Z$_2$ or across a first resistor (R$_3$) depending on the first thyristor (TH$_1$) being conducting or not; and a first capacitor (C$_1$) connected in parallel to the Zener diode (Z$_2$) and serving as a supply source for the said sensor-control circuit when minimum intensities of rectified current are flowing through the apparatus, characterized in that it contains protection means comprising a semi-conductor high gain component (T$_3$) series-connected with the first thyristor having an input (D) and a power output (S) and at least one control input (G), a transistor (T$_2$) connected in parallel between said control input (G) and the output of said semi-conductor component (T$_3$) in such a way that the said transistor (T$_2$), normally not saturated, becomes saturated when an overload or a power short circuit occur and that the saturation of said transistor (T$_2$) leads to the locking of the semi-conductor component (T$_3$) and thus to the current limitation (by R$_7$ and R$_8$) in the first thyristor (TH$_1$).

2. Detector apparatus of the two terminal type according to claim 1, wherein the base of said transistor (T$_2$) is biased by a bridge of second resistors (R$_6$, R$_7$) connected in parallel to said semi-conductor component (T$_3$), said detector further comprising, connected in parallel across its base-emitter junction, a second delay capacitor (C$_2$), the values of said second delay capacitor (C$_2$) and of the second resistors (R$_6$, R$_7$) being chosen such that the semi-conductor component (T$_3$) reaches a state of saturation before the said transistor (T$_2$) is saturated in its turn when said semi-conductor component and said transistor are put under tension.

3. Detector apparatus of the two terminal type according to claim 1 or 2, characterized in that it comprises third resistors (R$_5$, R$_{11}$) connected in series and after the Zener diode (Z$_2$) and a second thyristor (TH$_2$) connected in series to the semi conductor component (T$_3$) and in

parallel across the first thyristor ($TH_1$) and the Zener diode ($Z_2$), in such a way that said second thyristor ($TH_2$) substantially shunts the totality of the current flowing through the circuit and thus reduces the offset voltage due to said circuit arrangement, the gate of said second thyristor ($TH_2$) being connected to the common point of said third resistors ($R_5$, $R_{11}$) and the Zener diode ($Z_2$).

4. Detector apparatus of the two terminal type according to claim 3, wherein the first capacitor ($C_1$), adapted to act as a supply source for the sensor-control circuit unit (CAP), is connected in series to a first diode ($D_1$) and between said control input (G) of said semi conductor component ($T_3$) and the rectifying means ($D_4$—$D_7$), so as to effect the biassing of the control input (G) of said semi conductor component ($T_3$) when the second thyristor ($TH_2$) is conducting and thus to maintain said semi conductor component ($T_3$) in its saturated state.

5. Detector apparatus of the two terminal type according to claim 4, wherein said third resistors ($R_5$, $R_{11}$) comprise at least two series-connected resistors and said first capacitor ($C_1$) is connected to the common point of said third resistors ($R_5$, $R_{11}$), the values of said third resistors being chosen such that biassing of the second thyristor ($TH_2$) only occurs when the load current exceeds a certain threshold.

6. Detector apparatus of the two terminal type according to any one of claims 1 to 5, wherein the semi conductor component ($T_3$) is a transistor of the MOS type.

7. Detector apparatus of the two terminal type according to any one of claims 1 to 5, wherein the semi conductor component ($T_3$) is a Darlington circuit.